# EUROPEAN PATENT SPECIFICATION

(11) **EP 3 726 228 B1**
(45) Date of publication and mention of the grant of the patent: **07.06.2023**
(21) Application number: 18888921.6
(22) Date of filing: 11.12.2018
(51) Int. Cl.: G01R 15/20, G01R 19/00

(54) **CURRENT SENSOR**
STROMSENSOR
CAPTEUR DE COURANT

(30) Priority: 13.12.2017 JP 2017238494
(43) Date of publication of application: 21.10.2020
(73) Proprietor: Alps Alpine Co., Ltd., Ota-ku Tokyo 145-8501 (JP)
(72) Inventor: TAMURA, Manabu, Tokyo 145-8501 (JP); YAMAMOTO, Naoki, Tokyo 145-8501 (JP)
(74) Representative: Schmitt-Nilson Schraud Waibel Wohlfrom Patentanwälte Partnerschaft mbB
(86) International application number: PCT/JP2018/045575
(87) International publication number: WO 2019/117174

(56) References cited:
- WO-A1-2018/012034
- JP-A- 2010 230 329
- JP-A- 2013 113 631
- JP-A- 2015 145 838
- JP-A- 2015 145 839
- JP-U- H0 567 072
- US-A- 5 872 333
- US-A1- 2011 068 771
- US-A1- 2014 225 593
- US-A1- 2016 149 325

## Description

### Technical Field

The present invention relates to a current sensor that calculates a current value according to a magnetic field generated by a current under measurement.

### Background Art

US 2014/225593 A1 shows a current detector for detecting a current that flows through a busbar. A current detector includes a magnetic core, a current detection busbar, and an insulating casing.

US 2011/068771 A1 shows a current sensor for outputting a detection signal corresponding to a current flowing through a bus bar. The current sensor includes a magnetic core that concentrates and amplifies a magnetic field generated by the current near a detection portion of the bus bar. A magnetic detection element detects the magnetic field concentrated by the magnetic core and outputs an electrical signal corresponding to the detected magnetic field. The detection portion of the bus bar and the magnetic core are molded integrally with each other.

JP 2015 145838 A shows a current detection device comprising: a housing attached to a bus bar, a mounting circuit board on which is mounted a detection element for detecting the magnetic flux of a current flowing to the bus bar; and first and second magnetic shield plates attached to the housing so as to be disposed facing the bus bar and the mounting circuit board.

A current sensor described in PTL 1 is known as a current sensor that calculates a current value according to a magnetic field generated by a current. In the current sensor described in PTL 1, conductors in each of which a current under measurement flows and magnetic sensors each of which measures an induced magnetic field generated by the current under measurement are accommodated in a case having a lid. The current sensor has magnetic shields fixed by being integrally formed in the bottom portion and lid portion of the case.

In the current sensor in PTL 1, a signal from the magnetic sensor can be output to the outside by exposing a connector mounted on a circuit board at an opening portion formed in a side wall of the case and connecting a connector from the outside.

### Citation List

### Patent Literature

PTL 1: Japanese Unexamined Patent Application Publication No. 2017-102022

### Summary of Invention

### Technical Problem

The current sensor described in PTL 1 is formed so that a connector is provided at an end of the circuit board and the attachment and removal direction of a connector on the other side to be connected is parallel to the surface of the circuit board. Therefore, even when the connector on the other side is inserted or removed, a force is not so largely applied in a direction perpendicular to the surface of the circuit board.

On the other hand, with a current sensor, there is a case in which the connector is mounted in a direction perpendicular to the surface of the circuit board due to a positional relationship of a device to be connected or another reason. In this case, when the connector on the other side is inserted into or removed from the connector on the circuit board side, a force is applied directly in a direction perpendicular to the surface of the circuit board. Therefore, there is the fear that distortion occurs in the circuit board.

If distortion occurs in the circuit board as described above, there is the fear that a change occurs in a clearance between the conductor and a magnetic sensor mounted on the circuit board and a clearance between the magnetic sensor and the magnetic shield and the precision of the magnetic sensor is thereby lowered.

In a current sensor that outputs an output to the outside through a connector, the present invention addresses the above problem with the object of providing a current sensor that does not affect precision of the sensor even when a connector is inserted or removed.

### Solution to Problem

To achieve the above object, a current sensor according to claim 1 is provided.

According to the current sensor of the present invention, the magnetic sensor is provided in the fixed area enclosed by a plurality of fixing portions, and the connector is provided in the extended area extending from the fixed area. Also, stoppers are provided on the front surface and rear surface of the extended area so as to face through gaps. Therefore, when a connector on the other side is inserted into or removed from the connector, the extended portion can be warped in the plate thickness direction only by an amount equal to the gap with respect to the stopper. Since the fixed area is enclosed by the plurality of fixing portions, the warp is suppressed. Therefore, no change occurs in a positional relationship between the bus bar and the magnetic sensor, so precision of the current sensor can be assured.

In the current sensor of the present invention, the magnetic sensor is placed so that a sensitivity direction for the induced magnetic field becomes the X direction in an XY plane; of the plurality of fixing portions, at least two first fixing portions placed between the magnetic sensor and the connector are placed at two positions in the X direction; and the extended portion in which the connector is provided is adjacent to the fixed area with the first fixing portions interposed.

According to the current sensor of the present invention, the first fixing portions are placed at two positions in the X direction between the magnetic sensor and the connector. Therefore, when the connector is inserted or removed, if the extended portion, in which the connector is fixed, is warped, the warp in the X direction is suppressed by the first fixing portions at the two positions. Due to this, the warp in the X direction is suppressed in the fixed area as well, so the effect is not exerted on the sensitivity direction. This can assure precision of the current sensor.

Also, in the current sensor of the present invention, the fixing portions preferably include a second fixing portion formed at one position opposite to the first fixing portions toward the Y direction with the magnetic sensor interposed. According to this structure, the fixed area becomes triangular by being enclosed by the fixing portions at two positions in the X direction and the fixing portion at one position in the Y direction. Therefore, even if the extended portion is warped, the warp in the fixed portion is suppressed to a minimum.

Also, in the current sensor of the present invention, when a magnetic shield is provided in the lid portion, no change occurs in a positional relationship between the magnetic shield and the magnetic sensor, so precision of the current sensor having the magnetic shield can be assured.

### Advantageous Effects of Invention

According to the present invention, in a current sensor that outputs an output to the outside through a connector, a current sensor can be provided that does not affect precision of the sensor even when a connector is inserted or removed.

### Brief Description of Drawings

[Fig. 1] Fig. 1 is a perspective view indicating the outside shape of a current sensor, which is an example of an embodiment of the present invention.
[Fig. 2] Fig. 2 is an explanatory diagram indicating a state in which the lid portion of the current sensor in Fig. 1 is removed.
[Fig. 3] Fig. 3 is a perspective view indicating a state in which the current sensor in Fig 2 is further disassembled and the lid portion is reversed.
[Fig. 4] Fig. 4 is a cross-sectional view of the current sensor in Fig. 1 as taken along line IV-IV.
[Fig. 5] Fig. 5 is a cross-sectional view of the current sensor in Fig. 1 as taken along line V-V.
[Fig. 6] Fig. 6 is a perspective view indicating a state as viewed from the rear surface of the current sensor in Fig. 1.

### Description of Embodiments

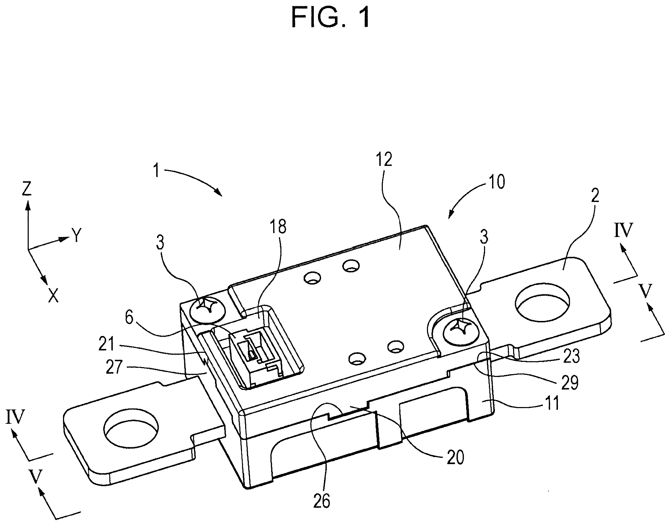

Next, a current sensor, which is an example of an embodiment of the present invention, will be described with reference to Fig. 1 to Fig. 6. The current sensor 1 in this embodiment is a sensor that can be used in a device requiring a large current such as a controller used in, for example, a hybrid vehicle or an electric car.

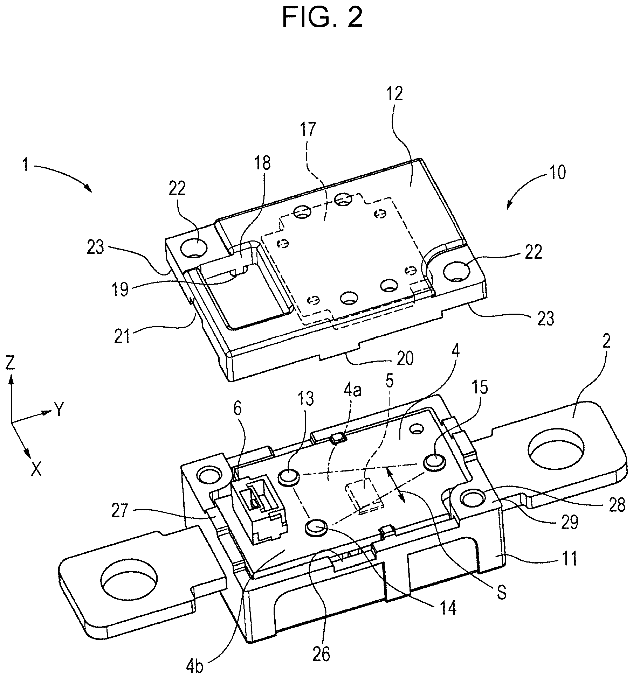

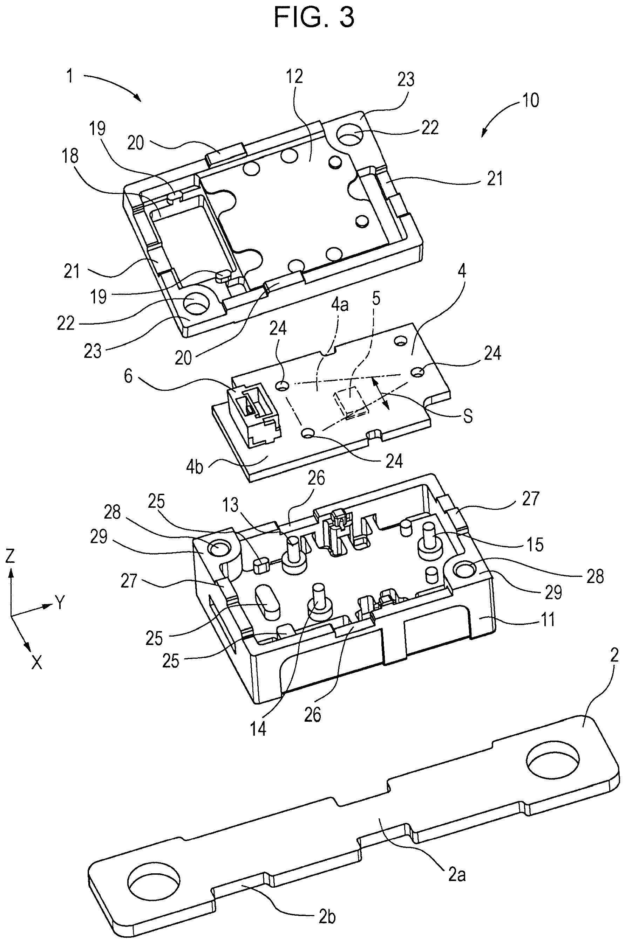

Fig. 1 is a perspective view indicating the outside shape of the current sensor 1, which is an example of an embodiment of the present invention. Fig. 2 indicates a state in which the lid portion 12 of the current sensor 1 is removed. A lid-portion magnetic shield 17 provided in the lid portion 12 and a magnetic sensor 5 provided on a circuit board 4 are indicated by the dotted lines. Fig. 3 is an exploded view of the current sensor 1, indicating a state in which a bus bar 2 is separated from a case body 11, the circuit board 4 is separated from the case body 11, and the lid portion 12 is reversed.

As indicated in Fig. 1, the current sensor 1 in this embodiment has the bus bar 2 in which a current flows and a case 10 that houses part of the bus bar 2. As indicated in Fig. 2, the case 10 is composed of the case body 11 in a box shape, the upper surface of which is open, and the lid portion 12 that covers the upper surface of the case body 11. The case body 11 and lid portion 12 are both made of an insulative synthetic resin. They are mutually fixed with two fixing screws 3.

Also, as indicated in Fig. 2, the insulative circuit board 4 is fixed with caulking portions 13, 14, and 15 at three positions and is housed inside the case body 11. These caulking portions 13, 14, and 15 are formed by making part of the case body 11 protrude in a columnar form, inserting the columnar portions into caulking holes 24, which will be described later, and thermally deforming the columnar portions from above. The caulking portions 13, 14, and 15 are equivalent to a plurality of fixing parts in the present invention.

In this embodiment, the caulking portions 13, 14, and 15 are composed of the caulking portions 13 and 14, which are aligned in the X direction in Fig. 2, and the caulking portion 15 disposed at one position distant to the right of the caulking portions 13 and 14 in the Y direction. In this embodiment, the caulking portions 13 and 14 are each equivalent to a first fixing portion in the present invention, and the caulking portion 15 is equivalent to a second fixing portion in the present invention.

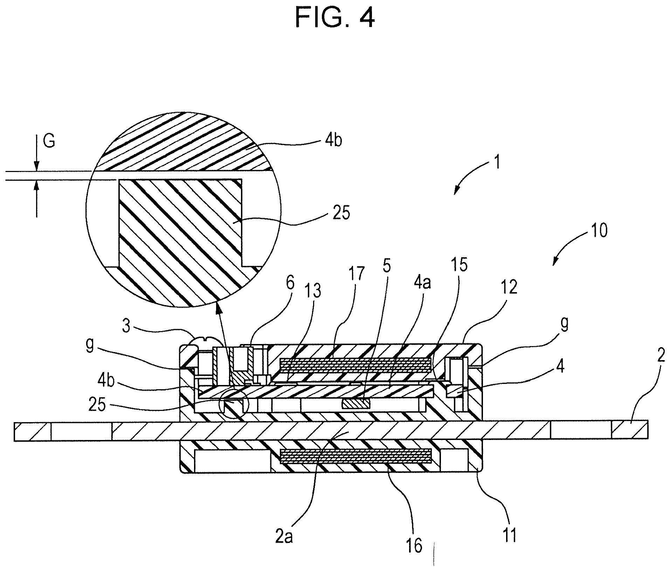

The caulking portion 15, which is the second fixing portion, is disposed at a position opposite to the caulking portions 13 and 14, each of which is the first fixing portion, in the Y direction with the magnetic sensor 5 interposed. Incidentally, in the case body 11, a case-body-side magnetic shield 16 formed integrally with a resin is provided (see Fig. 4 to Fig. 6).

In this embodiment, of an area on the circuit board 4, an area enclosed by the caulking portions 13, 14, and 15 at three positions is a fixed area 4a. Also, on the circuit board 4, an area to the left of the caulking portions 13 and 14 in the Y direction in Fig. 2 is an extended portion 4b extending from the fixed area 4a. That is, the extended portion 4b is provided with the caulking portions 13 and 14, equivalent to the first fixing portions, interposed. A connector 6, which will be described later, is mounted on the extended portion 4b. Therefore, the connector 6 is mounted at a position at which the connector 6 does not overlap the fixed area 4a in the X direction, which is the direction of an induced magnetic field. Also, since the caulking portions 13 and 14 are aligned in a direction parallel to the short side of the circuit board 4, the extended portion 4b, on which the connector 6 is mounted, is likely to be bent.

The magnetic sensor 5 is mounted on the rear surface of the fixed area 4a on the circuit board 4. The magnetic sensor 5 is a sensor that detects an induced magnetic field generated by a current flowing in the bus bar 2. In this embodiment, the magnetic sensor 5 is fixed to the circuit board 4 so that the sensitivity direction of the magnetic sensor 5 for the induced magnetic field becomes the X direction, indicated by the arrow S in Fig. 2, of an XY plane.

The connector 6 is mounted on the front surface of the extended portion 4b on the circuit board 4. A conductive terminal (omitted in the drawing) provided in the connector 6 is connected to a circuit pattern (omitted in the drawing) provided on the circuit board 4 and is connected to the magnetic sensor 5 through the circuit board 4. Also, the connector 6 is connected to a connector (omitted in the drawing, also true hereinafter) of another device so that a signal from the magnetic sensor 5 can be output to the outside of the case 10.

As indicated in Fig. 2, a metallic lid-portion magnetic shield 17 is provided in the lid portion 12. In this embodiment, when the lid portion 12 is formed, the lid-portion magnetic shield 17 is placed in a mold (omitted in the drawing, also true hereinafter) for injection molding and is molded integrally with a resin, which is a raw material. Also, in the lid portion 12, a connector opening 18 is formed through which the connector 6 is exposed to the outside.

In the lid portion 12, two lid-side stoppers 19 (stoppers) are provided in the vicinity of the connector opening 18 on the rear surface side, as indicated in Fig. 3. Also, a Y-direction positioning protrusion 20 is provided at two positions on outer walls enclosing the circumference on the rear surface side of the lid portion 12. The Y-direction positioning protrusion 20 performs positioning in the Y direction with respect to the case body 11.

Similarly, an X-direction positioning recess21 is provided at two positions in the X direction of the outer walls. The X-direction positioning recesses 21 perform positioning in the X direction. Also, on the rear side of the lid portion 12, the vicinity of an insertion hole 22 into which the fixing screw 3 is inserted is a lid-side Z-direction positioning portion 23 performing positioning in the Z direction.

As indicated in Fig. 3, the circuit board 4 is an insulative plate member in a substantially quadrangle shape, and caulking holes 24 through which the caulking portions 13, 14, and 15 provided inside the case body 11 are passed are formed on the circuit board 4 at three positions.

Inside the case body 11, a case-body-side stopper 25 (stopper) facing the rear surface of the circuit board 4 is provided at three positions. Also, in Fig. 3, the caulking portions 13, 14, and 15 yet to be caulked to the circuit board 4 are indicated, so they are in a columnar shape so that they can be passed through the caulking holes 24 in the circuit board 4.

At outer wall portions of the case body 11, a Y-direction positioning recess 26 performing positioning in the Y direction and an X-direction positioning protrusions 27 performing positioning in the X direction are each formed at two positions. Also, in the vicinity of a screw hole 28 in which the fixing screw 3 is fastened, a body-side Z-direction positioning portion 29 performing positioning in the Z direction is formed.

The bus bar 2 is a plate-like member extending in the Y direction. A to-be-detected portion 2a facing the magnetic sensor 5 is formed so that the width in X direction is narrower than the other portions. Also, a cutout 2b is formed in one side edge of the bus bar 2. This cutout 2b is used for positioning by using a positioning protrusion (omitted in the drawing) of the mold for injection molding when the bus bar 2 is formed integrally inside the case body 11. This prevents the bus bar 2 from being attached to the case body 11 in the opposite direction.

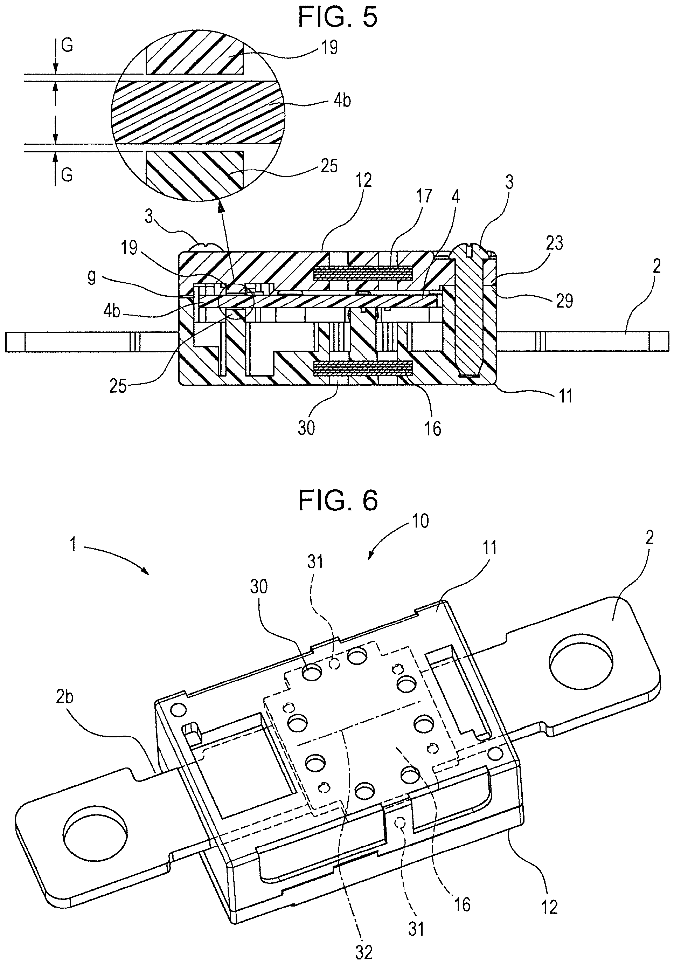

Next, the internal structure of the current sensor 1 in this embodiment will be described with reference to Fig. 4 and Fig. 5. Fig. 4 is a cross-sectional view along line IV-IV in Fig. 1 at the center position of the current sensor 1 in the X direction. Fig. 5 is a cross-sectional view along line V-V when a portion closer to the outer wall at front than in Fig. 4 is cut.

As indicated in Fig. 4, the circuit board 4 is positioned and fixed to the case body 11 with the caulking portions 13 and 15. On the rear surface side of the circuit board 4, the magnetic sensor 5 is mounted in the fixed area 4a. On the front surface side, the connector 6 is mounted in the extended portion 4b. On the rear surface side of the extended portion 4b on the circuit board 4, the case-body-side stopper 25 is placed so as to face the extended portion 4b with a gap G left between them.

On the front surface side of the extended portion 4b on the circuit board 4, the lid-side stopper 19 is placed so as to face the circuit board 4 with the gap G left between them, as indicated in Fig. 5. Also, on the rear surface side of the extended portion 4b on the circuit board 4, the case-body-side stopper 25 is placed so as to face the extended portion 4b with the gap G left between them.

In this embodiment, the minimum value of this gap G is set so that in consideration of the dimensional tolerances of the lid-side stopper 19, case-body-side stopper 25, and circuit board 4, even when the stopper side and circuit board 4 come closest to each other, the gap G does not become smaller than zero.

Also, the maximum value of the gap G is set to a magnitude enough to prevent a change in an output from the magnetic sensor 5 due to a positional relationship among the magnetic sensor 5, the caulking portions 13, 14, and 15, and the connector 6 on the circuit board 4 even when the extended portion 4b is warped. In this embodiment, the gap G is set so that it falls within a range from 0 mm to 0.1 mm.

Also, as for the outer wall portions of the lid portion 12 and case body 11, the lid-side Z-direction positioning portion 23 and body-side Z-direction positioning portion 29 abut each other as indicated in Fig. 5 to position the lid portion 12 and case body 11 in the Z direction. At other positions, a gap g is formed between the outer wall portions of the lid portion 12 and case body 11.

Also, the positioning of the lid portion 12 and case body 11 in the X direction is performed by fitting to the X-direction positioning recesses 21 provided in the lid portion 12 and to the X-direction positioning protrusions 27 provided on the case body 11, as indicated in Fig. 1. Similarly, positioning in the Y direction is performed by fitting to the Y-direction positioning protrusions 20 provided on the lid portion 12 and to the Y-direction positioning recesses 26 provided in the case body 11.

Fig. 6 is a perspective view when the current sensor 1 in this embodiment is viewed from rear surface side. In the rear surface of the case body 11, a recess 30 is formed, which is formed by a shield pressing portion (omitted in the drawing) provided in the mold for injection molding when the case-body-side magnetic shield 16 is molded integrally in the case body 11. In this embodiment, a total eight recesses 30 are provided, two for each of the four edges of the case-body-side magnetic shield 16.

Here, in Fig. 6, the position of each circle indicated by a dotted line on a side surface of the case body 11 is a gate position 31 of the mold for injection molding. Also, in Fig. 6, the dash-dot line extending in the Y direction at the center of the case-body-side magnetic shield 16 is a so-called weld line 32 on a resin. Incidentally, as a product, this weld line 32 does not appear on the front surface.

In this embodiment, the recess 30 formed when the case-body-side magnetic shield 16 is supported in the mold for injection molding is provided at two positions deviated from the weld line 32 in the X direction. Due to this, the structure is such that even if distortion occurs in the case body 11 and a stress is thereby generated in the weld line 32, cracks are not easily generated from the weld line 32.

Since the current sensor 1 in this embodiment has the structure described above, when a connector of another device is inserted into the connector 6, the connector 6 is pressed against the circuit board 4 in the Z direction. At this time, the extended portion 4b on the circuit board 4 is warped downward in the Z direction with the line interconnecting the caulking portions 13 and 14, which are the first fixing portion, taken as the boundary.

Since three case-body-side stoppers 25 are provided on the rear surface side of the extended portion 4b as indicated in Fig. 3, even if the extended portion 4b is warped as described above, the extended portion 4b is just warped by an amount equal to the gap G due to the case-body-side stoppers 25. After the connector of the other device has been attached, the extended portion 4b returns to the previous position due to its elasticity, eliminating the warp of the circuit board 4.

At this time, the fixed area 4a, enclosed by the caulking portions 13, 14, and 15, on the circuit board 4 is slightly affected by the warp of the extended portion 4b. However, after the connector of the other device has bee attached, the warp of the extended portion 4b is eliminated, so the effect does not remain in the positional relationship between the magnetic sensor 5 mounted on the fixed area 4a and the to-be-detected portion 2a of the bus bar 2.

Also, the caulking portions 13 and 14 are aligned in the X direction and this alignment direction matches the sensitivity direction S of the magnetic sensor 5. Therefore, even if a slight change occurs in the position of the fixed area 4a, in which the magnetic sensor 5 is mounted, due to the effect caused in the connector 6, the sensitivity direction S of the magnetic sensor 5 is not changed. Thus, there is no practical effect on the sensitivity of the magnetic sensor 5.

As described above, according to the current sensor 1 in this embodiment, the magnetic sensor 5 is not affected by the insertion or removal of a connector of another device into or from the connector 6, or even if the magnetic sensor 5 is affected, the magnetic sensor 5 is not practically affected. Therefore, the precision of the current sensor 1 can be stably maintained.

In the above embodiment, to suppress the warp of the extended portion 4b, the gap G between the circuit board 4 and the lid-side stopper 19 and case-body-side stopper 25 is preferably small. However, it is necessary to prevent the gap G from being reduced below zero even if the gap G is minimized due to the dimensional tolerances of individual members. This is because if the gap G becomes negative, the lid-side stopper 19 or case-body-side stopper 25 is kept in contact with the circuit board 4, placing the circuit board 4 in a deformed state, so the extended portion 4b is warped and the position of the magnetic sensor 5 in the fixed area 4a is also affected.

Also, in the above embodiment, the fixing portions that fix the circuit board 4 to the case body 11 are the caulking portions 13 and 14 provided as the first fixing portions, and the caulking portion 15 provided as the second fixing portion. When the fixed area 4a is formed with three caulking portions 13, 14, and 15 in this way, the fixed area 4a becomes triangular and thereby becomes less likely to be externally affected.

Incidentally, in the above embodiment, although the caulking portions 13, 14, and 15 are set at three positions, this is not a limitation. Caulking portions may be set at four or more positions. Also, in the above embodiment, although the gap G between the circuit board 4 and the lid-side stopper 19 and the gap G between the circuit board 4 and the case-body-side stopper 25 are a common magnitude, this is not a limitation. Different dimensions may be set.

Also, the case 10 is composed of two members, lid portion 12 and case body 11, and the lid portion 12 is formed so as to have a smaller thickness than the case body 11. However, the thickness of the lid portion 12 may be larger than the thickness of the case body 11 without being limited to the shape in the above embodiment.

Also, in the above embodiment, although the fixing portions that fix the circuit board 4 and case body 11 together are the caulking portions 13, 14, and 15, this is not a limitation. Press fitting the caulking hole 24 to a columnar portion formed inside the case body 11 may be performed. Alternatively, other fixing means such as screwing or riveting may be used.

Also, in the above embodiment, although each stopper is formed by a protrusion in an elliptical shape, this is not a limitation. Other shapes such as a columnar shape and prismatic shape suffice if they can minimize the warp of the circuit board 4.

Also, in the above embodiment, the lid-portion magnetic shield 17 and case-body-side magnetic shield 16 are formed integrally in the lid portion 12 and case body 11 and are fixed. However, this is not a limitation. The lid-portion magnetic shield 17 and case-body-side magnetic shield 16 may be fixed by using caulking portions as with the circuit board 4 or in another fixing method.

### Reference Sings List

- 1: current sensor
- 2: bus bar
- 4: circuit board
- 4a: fixed area
- 4b: extended portion
- 5: magnetic sensor
- 6: connector
- 10: case
- 11: case body
- 12: lid portion
- 13 to 15:: caulking portion
- 16: case-body-side magnetic shield
- 17: lid-portion magnetic shield
- 18: connector opening
- 19: lid-side stopper
- 25: case-body-side stopper

## Claims

1. A current sensor (1) comprising:
a bus bar (2) in which a current flows;
a magnetic sensor (5) that detects an induced magnetic field generated by the current flowing in the bus bar (2);
an insulative circuit board (4) on which the magnetic sensor (5) is mounted;
a connector (6) mounted on the circuit board (4) and connected to the magnetic sensor (5) through the circuit board (4), the connector (6) being capable of outputting a signal from the magnetic sensor (5) to an outside; and
a case (10) having a case body (11) and a lid portion (12), the case (10) housing the circuit board (4) and part of the bus bar (2); wherein
the circuit board (4) is fixed to the case body (11) with a plurality of fixing portions, and the magnetic sensor (5) is provided in a fixed area (4a) on the circuit board (4) enclosed by the plurality of fixing portions,
the connector (6) is provided in an extended portion (4b) on the circuit board (4) extending from the fixed area (4a),
**characterized in that**
stoppers (19, 25) are provided inside the case body (11) and the lid portion (12) so as to face a front surface and a rear surface of the extended portion (4b) through gaps;
the magnetic sensor (5) is placed so that a sensitivity direction for the induced magnetic field becomes an X direction in an XY plane;
of the plurality of fixing portions, at least two first fixing portions (13, 14) placed between the magnetic sensor (5) and the connector (6) are placed at two positions in the X direction; and
the extended portion (4b) in which the connector (6) is provided is adjacent to the fixed area (4a) with the first fixing portions (13, 14) interposed.

2. The current sensor (1) according to Claim 1, wherein the fixing portions include a second fixing portion (15) formed at one position opposite to the first fixing portions (13, 14) toward the Y direction with the magnetic sensor (5) interposed.

3. The current sensor (1) according to Claim 1 or 2, wherein a magnetic shield (17) is provided in the lid portion (12) .

## Patentansprüche

1. Stromsensor (1), aufweisend:
eine Sammelschiene (2), in der Strom fließt;
einen Magnetsensor (5), der ein induziertes Magnetfeld erfasst, das durch den in der Sammelschiene (2) fließenden Strom erzeugt wird;
eine isolierende Leiterplatte (4), auf der der Magnetsensor (5) angebracht ist;
einen Verbinder (6), der auf der Leiterplatte (4) angebracht ist und mit dem Magnetsensor (5) durch die Leiterplatte (4) verbunden ist, wobei der Verbinder (6) in der Lage ist, ein Signal von dem Magnetsensor (5) nach außen abzugeben; und
ein Gehäuse (10) mit einem Gehäusekörper (11) und einem Deckelbereich (12), wobei das Gehäuse (10) die Leiterplatte (4) und einen Teil der Sammelschiene (2) aufnimmt;
wobei die Leiterplatte (4) mit einer Mehrzahl von Befestigungsbereichen an dem Gehäusekörper (11) befestigt ist und der Magnetsensor (5) in einem feststehenden Bereich (4a) auf der Leiterplatte (4) vorgesehen ist, der von der Mehrzahl von Befestigungsbereichen umgeben ist,
wobei der Verbinder (6) in einem erweiterten Bereich (4b) auf der Leiterplatte (4) vorgesehen ist, der sich von dem feststehenden Bereich (4a) weg erstreckt,
**dadurch gekennzeichnet,**
**dass** Anschläge (19, 25) im Inneren des Gehäusekörpers (11) und des Deckelbereichs (12) derart vorgesehen sind, dass sie einer vorderen Oberfläche und einer hinteren Oberfläche des erweiterten Bereichs (4b) über Spalte hinweg zugewandt gegenüberliegen;
**dass** der Magnetsensor (5) derart platziert ist, dass eine Empfindlichkeitsrichtung für das induzierte Magnetfeld in einer XY-Ebene zu einer X-Richtung wird;
**dass** von der Mehrzahl von Befestigungsbereichen mindestens zwei erste Befestigungsbereiche (13, 14), die zwischen dem Magnetsensor (5) und dem Verbinder (6) platziert sind, an zwei Positionen in der X-Richtung platziert sind; und
**dass** der erweitere Bereich (4b), in dem der Verbinder (6) vorgesehen ist, unter Zwischenanordnung der ersten Befestigungsbereiche (13, 14) benachbart dem feststehenden Bereich (4a) vorgesehen ist.

2. Stromsensor (1) nach Anspruch 1,
wobei die Befestigungsbereiche einen zweiten Befestigungsbereich (15) aufweisen, der an einer Position gegenüber den ersten Befestigungsbereichen (13, 14) in Richtung der Y-Richtung ausgebildet ist, wobei der Magnetsensor (5) dazwischen angeordnet ist.

3. Stromsensor (1) nach Anspruch 1 oder 2,
wobei in dem Deckelbereich (12) eine magnetische Abschirmung (17) vorgesehen ist.

## Revendications

1. Capteur de courant (1) qui comprend :
une barre collectrice (2) dans laquelle circule un courant ;
un capteur magnétique (5) qui détecte un champ magnétique induit généré par le courant qui circule dans la barre collectrice (2) ;
une carte isolante de circuits imprimés (4) sur laquelle est monté le capteur magnétique (5) ;
un connecteur (6) monté sur la carte de circuits imprimés (4) et connecté au capteur magnétique (5) par l'intermédiaire de la carte de circuits imprimés (4), le connecteur (6) étant capable d'émettre un signal à partir du capteur magnétique (5) en direction de l'extérieur ; et
un boîtier (10) qui possède un corps de boîtier (11) et une portion (12) faisant office de couvercle, la carte de circuits imprimés (4) et une partie de la barre collectrice (2) venant se loger dans le boîtier (10) : dans lequel
la carte de circuits imprimés (4) est fixée au corps de boîtier (11) avec un certain nombre de portions faisant office de fixation, et le capteur magnétique (5) est prévu dans une zone fixe (4a) sur la carte de circuits imprimés (4) entourée par lesdites plusieurs portions faisant office de fixation ;
le connecteur (6) est prévu dans une portion étendue (4b) sur la carte de circuits imprimés (4) qui s'étend à partir de la zone fixe (4a) ;
**caractérisé en ce que** l'on prévoit des arrêts (19, 25) à l'intérieur du corps de boîtier (11) et de la portion (12) faisant office de couvercle pour faire face à une surface avant et à une surface arrière de la portion étendue (4b) par l'intermédiaire d'espaces libres ;
le capteur magnétique (5) est placé d'une manière telle qu'une direction de sensibilité pour le champ magnétique induit devient une direction X dans un plan XY ;
parmi lesdites plusieurs portions faisant office de fixation, au moins deux premières portions faisant office de fixation (13, 14) disposées entre le capteur magnétique (5) et le connecteur (6) sont placées à deux endroits dans la direction X ; et
la portion étendue (4b) dans laquelle on prévoit le connecteur (6) est disposée en position adjacente à la zone fixe (4a), les premières portions faisant office de fixation (13, 14) étant intercalées.

2. Capteur de courant (1) selon la revendication 1, dans lequel les portions faisant office de fixation englobent une deuxième portion de fixation (15) que l'on obtient à un endroit opposé à celui des premières portions faisant office de fixation (13, 14) dans la direction Y, le capteur magnétique (5) étant intercalé.

3. Capteur de courant (1) selon la revendication 1 ou 2, dans lequel un champ magnétique (17) est prévu dans la portion (12) faisant office de couvercle.
